# EUROPEAN PATENT APPLICATION

(11) **EP 2 006 896 A1**
(43) Date of publication of application: **24.12.2008**
(21) Application number: 07707466.4
(22) Date of filing: 26.01.2007
(51) Int. Cl.: H01L 21/56

(54) **RESIN SEALING/MOLDING APPARATUS**

(30) Priority: 20.03.2006 JP 2006076280
(71) Applicant: Towa Corporation, Kyoto 6018105 (JP)
(72) Inventor: URAGAMI, Hiroshi, Kyoto-shi Kyoto 601-8105 (JP); NAKAMURA, Mamoru, Kyoto-shi Kyoto 601-8105 (JP); TAKAHASHI, Masanobu, Kyoto-shi Kyoto 601-8105 (JP); FUJINO, Kinya, Kyoto-shi Kyoto 601-8105 (JP); TSUTAFUJI, Katsunori, Kyoto-shi Kyoto 601-8105 (JP)
(74) Representative: Lipscombe, Martin John
(86) International application number: PCT/JP2007/051234
(87) International publication number: WO 2007/108228

(57) **Abstract**

Resin molding apparatus (1) includes in unit (4), press unit (7) and out unit (9). The in unit (4) transfers not only pre-molding substrate (17) but also resin material (18). The press unit (7) includes multiple mold assemblies (5). The out unit (9) transfers molded substrate (20) having been resin-sealed within the mold assemblies (5). Further, the resin sealing/molding apparatus (1) includes not only carrier rail (10) but also demounting means (12) and supply means (11) traveling along the carrier rail (10). Furthermore, multiple press units (7) in the state of being linked with each other are disposed between the in unit (4) and the out unit (9).

## Description

### TECHNICAL FIELD

The present invention relates to a resin sealing/molding apparatus loaded with mold assemblies, and more particularly, it relates to a resin sealing/molding apparatus sealing/molding a plurality of electronic components mounted on a substrate with a resin material.

### BACKGROUND ART

The requirement for size increase of a substrate for reducing the cost has recently grown stronger regardless of the type of the substrate, bonding/nonbonding and the system. In addition to this, the requirement for thinning of the substrate grows stronger. Further, extension of a wire length and reduction of the interval between wires are required, in order to increase the number of terminals of semiconductor chips which are electronic components of an IC (Integration Circuit) or the like, stacking of the semiconductor chips and thinning of a package. In addition, an operation of collectively efficiently sealing/molding a plurality of electronic components loaded on various substrates other than a conventional strip substrate is strongly required.

Therefore, a mold assembly formed by an upper mold section, a lower mold section and an intermediate mold section is employed as a mold structure, for example. Further, a mold release film covering a cavity surface formed by the lower mold section and the intermediate mold section is employed. The mold release film is held by the lower mold section and the intermediate mold section, and covers the overall surface of a cavity.

In resin molding, a pre-molding substrate is supplied to a cavity space. The pre-molding substrate is mounted on a prescribed position of the lower surface of the upper mold section while directing semiconductor chips downward. Further, a necessary volume of resin is supplied into the cavity space. Thereafter the upper mold section, the intermediate mold section and the lower mold section are closed. At this time, the cavity space is cut off from the outside air. Evacuation is executed in this state. Consequently, a complete internal air isolation space is formed.

When evacuation is executed, the upper mold section, the intermediate mold section and the lower mold section are pressed against each other, and the upper end of the lower mold section comes into contact with the periphery of the pre-molding substrate while the mold release film is interposed therebetween. In this state, further, only the lower mold section moves upward, whereby the mold assembly is completely closed. At this time, the chips are sealed/molded while the resin material is molten by heating.

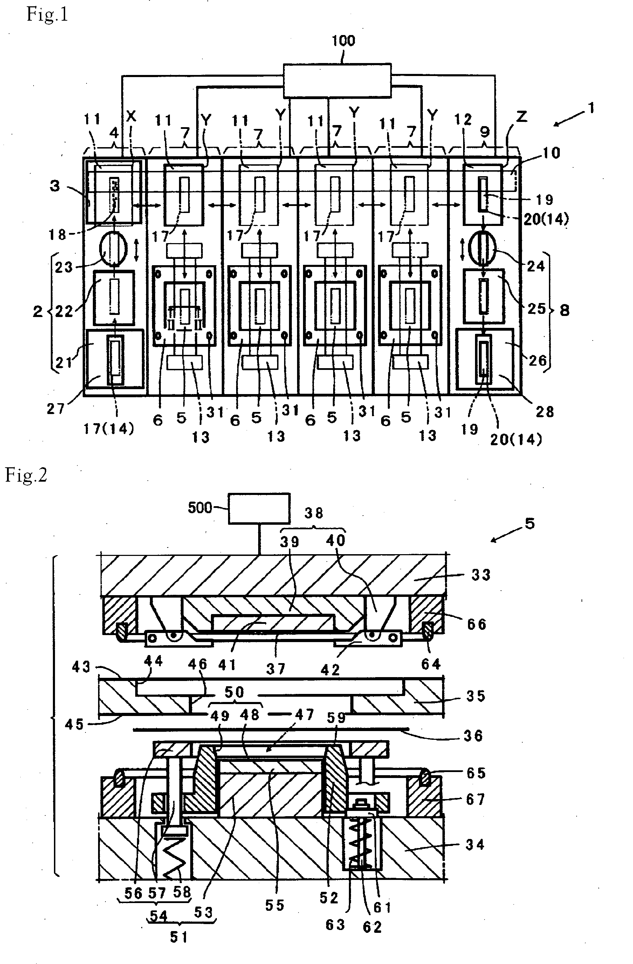

Then, only the lower mold section moves downward while the molded substrate is mounted on the upper mold section. At this time, the mold release film is present between the lower mold section and the compact, whereby the compact excellently separates from the lower mold section (refer to pages 6 to 14 and Figs. 2 to 13 of Japanese Patent Laying-Open No. 2005-225133, for example).

Japanese Patent Laying-Open No. 2005-225133 discloses a resin molding apparatus loaded with the aforementioned mold assembly. The resin sealing/molding apparatus includes a molding material supply portion for supplying the respective ones of a compact and a resin material resin-molding the compact, a molding portion having a mold for resin molding, a compact takeout portion for taking out the resin-molded compact and a control portion controlling the overall apparatus.

The aforementioned apparatus has a substantially square outline in a plan view, whereby the efficiency at the time of operating with the aforementioned apparatus is improved. Further, this apparatus has a supply/takeout portion formed by integrating the molding material supply portion and the compact takeout portion with each other. The supply/takeout portion, the molding portion and the control portion are rendered attachable to/detachable from each other, and these are so disposed as to integrally have a square outline.

A resin sealing/molding apparatus loaded with the mold assembly disclosed in Japanese Patent Laying-Open No. 2005-225133 and capable of supplying a molding material and taking out a compact from a supply/takeout portion in the horizontal direction is disclosed in pages 3 to 7 and Figs. 1 and 2 of Japanese Patent Laying-Open No. 2005-238652.
Patent Document 1: Japanese Patent Laying-Open No. 2005-225133 (pages 6 to 14, Figs. 2 to 13)
Patent Document 2: Japanese Patent Laying-Open No. 2005-238652 (pages 3 to 7, Figs. 1 and 2)

### DISCLOSURE OF THE INVENTION

### PROBLEMS TO BE SOLVED BY THE INVENTION

According to the aforementioned resin molding apparatus disclosed in Japanese Patent Laying-Open No. 2005-238652, the operation can be executed with high efficiency in a case of completing all steps related to the molding step with only this apparatus or a case of executing only a step of molding individual semiconductor chips mounted on a substrate.

In general, however, a bonding step of mounting the chips on the substrate and a dicing step of cutting the molded substrate after the molding step in units of the semiconductor chips are carried out before performing the molding step. In order to efficiently and smoothly execute these plurality of steps, it is conceivably necessary to substantially linearly and continuously move the substrate in the bonding step, the molding step and the dicing step for improving productivity.

According to the disposition of a plurality of units constituting the conventional resin molding apparatus, however, the substrate cannot be substantially linearly and continuously moved. More specifically, even if the substrate can be efficiently and smoothly moved from the unit for carrying out the bonding step to the unit for carrying out the subsequent molding step in order to supply the molding material and take out the compact in the horizontal direction of the supply/takeout portion, the substrate cannot be efficiently and smoothly moved when the molded substrate is moved to the unit for carrying out the subsequent dicing step or contrarily thereto.

The present invention has been proposed in consideration of the aforementioned problem, and an object thereof is to provide a resin sealing/molding apparatus capable of efficiently and smoothly executing the aforementioned plurality of steps.

### MEANS FOR SOLVING THE PROBLEMS

The resin sealing/molding apparatus comprises an in unit, a plurality of press units and an out unit. The in unit has a substrate mechanism transferring a pre-molding substrate mounted with a plurality of semiconductor chips and a resin material mechanism transferring a resin material. Each of the plurality of press units includes a press mechanism loaded with a mold assembly having an upper mold section, a lower mold section and an intermediate mold section provided between the upper mold section and the lower mold section. The out unit has a substrate mechanism transferring a molded substrate resin-sealed in the mold assembly. The apparatus further comprises a carrier rail, a supply mechanism and a demounting mechanism. The carrier rail is so provided as to cross the in unit, the press units and the out unit. The supply mechanism travels along the carrier rail, and supplies the pre-molding substrate into the mold assembly. The demounting mechanism travels along the carrier rail, and demounts the molded substrate from the mold assembly. The apparatus further comprises a control mechanism controlling the in unit, the press units and the out unit. Further, the plurality of press units are disposed between the in unit and the out unit in a state linked with each other.

Each of the plurality of mold assemblies includes a film supply mechanism unit supplying a tensioned mold release film between the intermediate mold section and the lower mold section and an evacuation mechanism unit executing evacuation of the mold assembly while the internal space of the mold assembly is cut off from the outside air.

### EFFECTS OF THE INVENTION

According to the present invention, the plurality of press units are linked with each other and disposed between the in unit and the out unit, whereby a series of resin sealing/molding steps can be efficiently carried out.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a plan view of a resin sealing/molding apparatus for semiconductor chips according to an embodiment.
Fig. 2 is a sectional view taken along the line II-II in Fig. 1, showing a mold assembly for compression molding loaded on the resin sealing/molding apparatus.
Fig. 3 is a sectional view showing a state immediately before a pre-molding material is supplied to the mold assembly of the resin sealing/molding apparatus shown in Fig. 1.
Fig. 4 is a perspective view showing a state where a resin material is supplied into a cavity of the mold assembly of the resin sealing/molding apparatus shown in Fig. 1.
Fig. 5 is a sectional view showing a closed state of the mold assembly of the resin sealing/molding apparatus shown in Fig. 2 and a molded substrate.

### DESCRIPTION OF THE REFERENCE SIGNS

1 resin sealing/molding apparatus, 2, 8 substrate mechanism, 3 resin material mechanism, 4 in module unit (in unit), 5 mold assembly for compression molding, 6 press mechanism, 7 press module unit (press unit), 9 out module unit (out unit), 10 carrier rail, 11 supply mechanism, 12 demounting mechanism, 13 film supply mechanism unit (film unit), 14 substrate, 15 semiconductor chip (electronic component), 16 wire, 17 pre-molding substrate, 18 resin material, 19 resin compact (package), 20 molded substrate (product), 21 substrate supply portion, 22 substrate adjusting portion, 23, 24 substrate transfer portion, 25 substrate receiving portion, 26 product storage portion, 27 in magazine, 28 out magazine, 30 substrate periphery, 31 unmounted surface, 32 cured resin, 33 upper mold section, 34 lower mold section, 35 intermediate mold section, 36 mold release film, 37 substrate mounting surface, 38 substrate fixing mechanism, 39, 53 adsorbing/fixing portion, 40, 54 holding/fixing portion, 41, 55 permeable member, 42 chucking pawl, 43 upper mold section side mold surface, 44 upper storage portion, 45 lower mold section side mold surface, 46 lower storage portion, 47 cavity, 48 lower mold section cavity surface, 49 cavity side surface, 50 cavity surface, 51 film fixing mechanism, 52 cavity member, 56 holding member, 57 mounting bar, 58, 63 elastic member, 59 substrate contact portion, 60 chucking pawl storage portion, 61 receiving member, 62 mounting member, 64 upper sealing member, 65 lower sealing member, 66 upper seal fixing member, 67 lower seal fixing member, X supply position, Y advancing/retracting position, Z delivery position.

### BEST MODES FOR CARRYING OUT THE INVENTION

A resin sealing/molding apparatus according to this embodiment is now described in detail with reference to Figs. 1 to 4.

The resin sealing/molding apparatus 1 (hereinafter referred to as "apparatus 1") according to this embodiment comprises an in module unit 4 (hereinafter referred to as "in unit 4"), press module units 7 (hereinafter referred to as "press units 7") and an out module unit 9 (hereinafter referred to as "out unit 9"), as shown in Fig. 1.

In unit 4 includes a substrate mechanism 2 and a resin material mechanism 3. Substrate mechanism 2 transfers pre-molding substrates 17 in an aligned manner. Resin material mechanism 3 transfers pre-molding resin materials 18 in an aligned manner. Press units 7 are attachable to/detachable from in unit 4, and include press mechanisms 6. Each press mechanism 6 has a mold assembly 5 for compression molding including three mold sections for compression molding, i.e., an upper mold section 33, an intermediate mold section 35 and a lower mold section 34.

Out unit 9 is attachable to/detachable from press units 7, and includes a substrate mechanism 8. Substrate mechanism 8 receives molded substrates 20 compression-molded and resin-sealed in mold assemblies 5, transfers the same and stores the same in a storing portion.

Apparatus 1 further comprises a carrier rail 10, a supply mechanism 11, a demounting mechanism 12, a control mechanism 100, film supply mechanism units 13 and an evacuation mechanism unit 500. Carrier rail 10 is so provided as to cross in unit 4, press units 7 and out unit 9. Supply mechanism 11 reciprocates along carrier rail 10, and substantially simultaneously and individually supplies pre-molding substrates 17 and resin materials 18 which are pre-molding materials into mold assemblies 5. Demounting mechanism 12 reciprocates along carrier rail 10, and demounts molded substrates 20 from mold assemblies 5. Control mechanism 100 controls overall apparatus 1. More specifically, control mechanism 100 controls in unit 4, press units 7 and out unit 9. Each film supply mechanism unit 13 supplies a tensioned mold release film 36 between the mold surfaces of each intermediate mold section 35 and each lower mold section 34. Evacuation mechanism unit 500 discharges air from each mold assembly 5 while an upper sealing member 64 is interposed between the mold surfaces of upper mold section 33 and intermediate section 35.

In apparatus 1, not one but a plurality of, e.g., four press units 7 are provided between in unit 4 and out unit 9, in order to improve productivity in a resin sealing, i.e., molding step. Therefore, four substrates 14 at a maximum can be individually and substantially simultaneously resin-sealed by compression molding with four mold assemblies 5 in one resin sealing step.

Each mold assembly 5 is substantially similar in structure to the mold assembly disclosed in Japanese Patent Laying-Open No. 2005-225133, and can efficiently compression-mold various substrates disclosed in Japanese Patent Laying-Open No. 2005-225133.

In this embodiment, both of mold release film molding and evacuation molding are executed, as shown in Fig. 1. When mold assemblies 5 formed by upper mold sections 33, intermediate mold sections 35 and lower mold sections 34 are employed, fixing mechanisms for driving the intermediate mold sections are provided independently of press mechanisms 6. The fixing mechanisms (not shown) for driving the intermediate mold sections can individually vertically move intermediate mold sections 35.

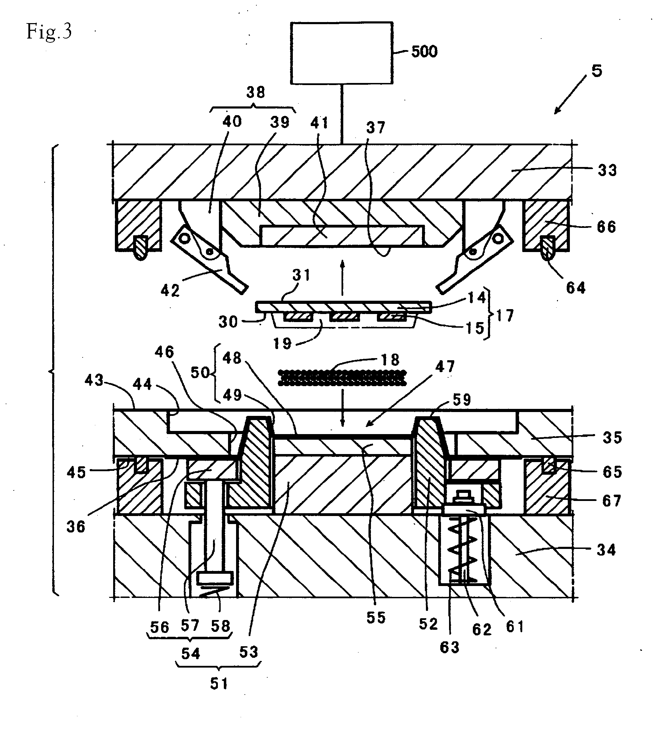

Each pre-molding material employed in this embodiment is formed by pre-molding substrate 17 and resin material 18, as shown in Fig. 3. Pre-molding substrate 17 is formed by a plurality of semiconductor chips 15 (hereinafter referred to as "chips 15") loaded on prescribed portions of each substrate 14 and substrate 14 before resin sealing/molding including a plurality of wires (not shown) electrically connecting substrate 14 and chips 15 with each other.

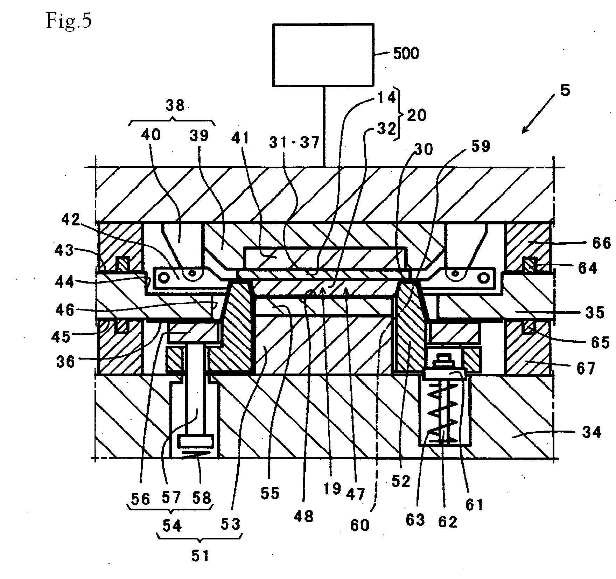

Resin material 18 is granular resin for sealing chips 15 provided on pre-molding substrate 17. On the other hand, a molded material is each molded substrate 20, i.e., a product, provided with a cured resin compact 19, i.e., a package, as shown in Fig. 5.

Substrate 14 mounted with plurality of chips 15 may be a wire-bonded substrate, or a flip chip substrate or a wafer substrate constituting a wafer-level package. Substrate 14 may have an arbitrary shape such as a circular or polygonal shape, in place of a strip shape. The material of substrate 14 may be a metal for a lead frame or the like, or plastic, ceramic, glass or another material referred to as a PC board. Resin material 18 may be tablet resin, liquid resin, powdered resin or sheet resin, in place of the granular resin. In place of such a resin material, particulate resin larger in particle diameter than powder and smaller in particle diameter than granules may be employed.

Substrate mechanism 2 of in unit 4 includes a substrate supply portion 21 supplying each pre-molding substrate 17, a substrate adjusting portion 22 adjusting the position and attitude of one pre-molding substrate 17 transferred from substrate supply portion 21 and a substrate transfer portion 23 transferring one pre-molding substrate 17 whose position and attitude are adjusted in substrate adjusting portion 22 to supply mechanism 11.

Resin material mechanism 3 of in unit 4 includes a storage portion and an adjusting portion. The storage portion is a resin stocker or the like storing resin material 18, granular resin in this embodiment, used in sealing/molding. The adjusting portion can adjust the volume of resin material 18, and supplies resin material 18 of a volume corresponding to one substrate 14, i.e., pre-molding substrate 17 used in one resin sealing step to a storage holder (not shown) such as a resin tray.

Substrate mechanism 8 of out unit 9 includes a substrate transfer portion 24 taking out one molded substrate 20 from demounting mechanism 12 and transferring the same, a substrate receiving portion 25 receiving one molded substrate 20 transferred by substrate transfer portion 24 and a product storage portion 26 finally storing one molded substrate 20 transferred from substrate receiving portion 25.

While substrate mechanism 2 of in unit 4 and substrate mechanism 8 of out unit 9 are mechanisms employed before and after resin sealing/molding respectively, these have substantially similar mechanisms since each of the objects treated by the same is substrate 14. According to this, the manufacturing cost for apparatus 1 can be reduced by rendering the components of in unit 4 and those of out unit 9 common to each other.

A series of resin sealing steps compression-molding pre-molding substrate 17 into molded substrate 20 and resin-sealing the same with apparatus 1 according to this embodiment, i.e., the flow of substrate 1 is now described with reference to Fig. 1.

In substrate mechanism 2 of in unit 4, one pre-molding substrate 17 is first transferred from an in magazine 27 storing plurality of pre-molding substrates 17 provided on substrate supply portion 21 to substrate adjusting portion 22 by proper means (not shown) such as a pusher/gripper feeder. Thereafter in substrate adjusting portion 22, one pre-molding substrate 17 is set on a prescribed position of mold assembly 5 in a prescribed attitude. Then, one pre-molding substrate 17 is transferred from substrate adjusting portion 22 to supply mechanism 11 by pickup means (not shown) provided on substrate transfer portion 23.

In resin material mechanism 3 of in unit 4, on the other hand, resin material 18 of the volume necessary for sealing one pre-molding substrate 17 is stored in the resin tray by the adjusting portion of resin material mechanism 3, and transferred to supply mechanism 11. On a supply position X of in unit 4, therefore, supply mechanism 11 has one pre-molding substrate 17 on the upper surface, and has resin material 18 of the volume necessary for sealing one pre-molding substrate 17 on the lower surface.

Then, supply mechanism 11 travels along carrier rail 10 up to an advancing/retracting position Y on which the same can advance into and retract from mold assembly 5 loaded on press mechanism 6 of press unit 7 from in unit 4 in the state having one pre-molding substrate 17 and resin material 18 necessary for resin-sealing one pre-molding substrate 17.

Then, supply mechanism 11 moves in a direction perpendicular to carrier rail 10, and advances into mold assembly 5 of press mechanism 6. Thus, one pre-molding substrate 17 and resin material 18 of the volume necessary for resin-sealing one pre-molding substrate 17 provided on supply mechanism 11 are set on the prescribed position of mold assembly 5, as shown in Fig. 3.

Then, one pre-molding substrate 17 is resin-sealed by compression molding. Consequently, one molded substrate 20, i.e., the product is completed. At this time, supply mechanism 11 moves to advancing/retracting position Y and stands by, so that completed one molded substrate 20 can be taken out from mold assembly 5.

Then, demounting mechanism 12 moves from advancing/retracting position Y in the direction perpendicular to carrier rail 10 and advances into mold assembly 5. Then, one molded substrate 20 is taken out from mold assembly 5 by demounting mechanism 12. Thereafter demounting mechanism 12 carries one molded substrate 20 from mold assembly 5 to advancing/retracting position Y.

Then, demounting mechanism 12 travels along carrier rail 10 from press unit 7 to a delivery position Z of out unit 9 in the state including one molded substrate 20. Then, one molded substrate 20 is transferred to substrate receiving portion 25 by pickup means (not shown) provided on substrate transfer portion 24. Then, one molded substrate 20 is transferred from substrate receiving portion 25 to an out magazine 28 storing molded substrates 20 in product storage portion 26 and stored by proper means (not shown) such as a pusher/gripper feeder, the aforementioned pickup means or another pickup means (not shown).

In apparatus 1 according to this embodiment, the series of resin sealing steps including inspection and preheating up to conversion of one pre-molding substrate 17 to one molded substrate 20 are executed with four mold assemblies 5 for compression molding shown in Fig. 1.

The structure of each mold assembly 5 is now specifically described with reference to Figs. 2 to 5. Mold assembly 5 includes upper mold section 33, lower mold section 34 opposed to upper mold section 33 and intermediate mold section 35 disposed between upper mold section 33 and lower mold section 34. According to this embodiment, compression molding is executed with mold assembly 5 and mold release film 36. Thus, pre-molding substrate 17 shown in Fig. 3 is converted to molded substrate 20 shown in Fig. 5.

Upper mold section 33 includes a substrate fixing mechanism 38, as shown in Fig. 2. Substrate fixing mechanism 38 fixes pre-molding substrate 17 to a substrate mounting surface 37 by means of holding and adsorption while directing chips 15 downward.

Substrate fixing mechanism 38 includes both of a substrate adsorbing/fixing portion 39 adsorbing substrate 14 (pre-molding substrate 17 or molded substrate 20) and a substrate holding/fixing portion 40 holding substrate 14. This structure is so employed as to more reliably fix substrate 14 to substrate mounting surface 37.

Substrate adsorbing/fixing portion 39 has a substrate permeable member 41 made of a material such as a metal or ceramic having air permeability and heat resistance for adsorbing an unmounted surface 31 of substrate 14. Air, moisture, gas etc. in mold assembly 5 are forcibly discharged toward the external space through a passage, a pipe and a valve communicating with substrate permeable member 41 from one main surface of substrate 14 opposite to substrate mounting surface 37 corresponding to the lower surface of substrate permeable member 41. At this time, the function of evacuation mechanism unit 500 is utilized.

In other words, substrate 14 is fixed by forcible suction of substrate adsorbing/fixing portion 39, to bring unmounted surface 31 thereof into contact with substrate mounting surface 37 within the lower surface of substrate permeable member 41.

Substantially at the same time when molded substrate 20 is released from substrate holding/fixing portion 40, air is fed through a passage similar to the passage at the time of sucking substrate 14. Thus, unmounted surface 31 of molded substrate 20 is reliably separated from substrate mounting surface 37 of the mold surface of upper mold section 33.

Substrate holding/fixing portion 40 has a plurality of chucking pawls 42, eight chucking pawls 42 in this embodiment, for stopping a substrate periphery 30 around substrate adsorbing/fixing portion 39.

Chucking pawls 42 generally extend in a substantially horizontal direction, and stand by in a state not in contact with substrate mounting surface 37. When substrate 14, i.e., pre-molding substrate 17 or molded substrate 20 is mounted on substrate fixing mechanism 38 or substrate 14 is dismounted from substrate fixing mechanism 38, chucking pawls 42 so pivot from the state extending in the horizontal direction that the forward ends thereof approach the upper surface of intermediate mold section 35 or pivot oppositely thereto. Thus, chucking pawls 42 are opened or closed.

Both of adsorption/fixation with substrate adsorbing/fixing portion 39 and holding/fixing with substrate holding/fixing portion 40 are employed as described above, whereby various substrates 14 can be reliably fixed to substrate mounting surface 37 of the mold surface of upper mold section 33, as shown in Fig. 5. Therefore, the position of substrate 14 does not deviate downward or in the horizontal direction with respect to upper mold section 33.

Intermediate mold section 35 has an upper storage portion 44 having an opening in an upper mold section side mold surface 43 of upper mold section 33 and a lower storage portion 46 having an opening in a lower mold section side mold surface 45 of lower mold section 34, as shown in Fig. 2. Upper storage portion 44 and lower storage portion 46 are continuous with each other, and constitute a through-hole extending in the vertical direction.

When upper mold section 33 and intermediate mold section 35 are closed, chucking pawls 42 of substrate fixing mechanism 38 are stored in upper storage portion 44, not to come into contact with intermediate mold section 35. A cavity 47 of lower mold section 34 passes through lower storage portion 46, to reach upper storage portion 44.

Mold release film 36 is inserted between lower mold section side mold surface 45 of intermediate mold section 35 and the upper surface of lower mold section 34 in a tensioned state when mold assembly 5 show in Fig. 2 is opened.

Lower mold section 34 includes cavity 47 for molding resin compact 19 of substrate 14, i.e., a package, as shown in Figs. 2 and 3. Cavity 47 has a lower mold section cavity surface 48. Lower mold section cavity surface 48 has a shape corresponding to the top surface of resin compact 19.

A cavity surface 50 constituting the overall surface of cavity 47 is constituted of lower mold section cavity surface 48 and a cavity side surface 49, as shown in Fig. 2. Lower mold section 34 includes a film fixing mechanism 51 sucking mold release film 36 toward lower mold section cavity surface 48 and fixing the same to lower mold section 34 and a cavity member 52 constituting lower mold section cavity surface 48 and cavity side surface 49.

Film fixing mechanism 51 includes both of a film adsorbing/fixing portion 53 adsorbing mold release film 36 and a film holding/fixing portion 54 holding mold release film 36. This structure is so employed as to more reliably fix mold release film 36 along the molding surface, at least the overall surface of cavity 47.

Film adsorbing/fixing portion 53 includes a film permeable member 55 of a material such as a metal or ceramic having air permeability and heat resistance for sucking mold release film 36 toward lower mold section cavity surface 48. Air, moisture, gas etc. are forcibly discharged toward the external space from the lower surface opposite to lower mold section cavity surface 48 corresponding to the upper surface of film permeable member 55 through a passage, a pipe and a valve communicating with film permeable member 55. This is implemented by evacuation mechanism unit 500.

Mold release film 36 is forcibly adsorbed toward lower mold section cavity surface 48 of film permeable member 55 by film adsorbing/fixing portion 53. Thus, mold release film 36 is reliably fixed to the mold surface of lower mold section 34.

When only lower mold section 34 moves downward, air is sprayed to molded substrate 20 through the same passage as that for adsorbing mold release film 36. Thus, resin compact 19, i.e., the package reliably separates from lower mold section 34 along with mold release film 36.

Film adsorbing/fixing portion 53 is provided substantially at the center of lower mold section 34, and film holding/fixing portion 54 is provided around film adsorbing/fixing portion 53 along with cavity member 52. Film holding/fixing portion 54 includes a holding member 56 for coming into contact with mold release film 36 and holding mold release film 36, a plurality of mounting bars 57 vertically extending in Fig. 2 and an elastic member 58 formed by a spring or the like elastically supporting holding member 56 and mounting bars 57 in the vertical direction.

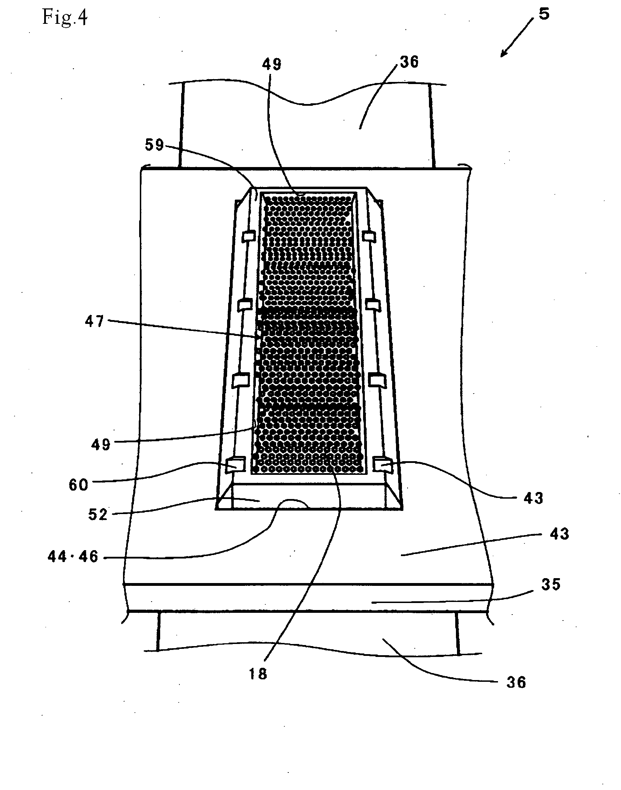

When mold assembly 5 shown in Fig. 2 is opened, elastic member 58 returns to an expanding state so that the upper surface of holding member 56 protrudes upward beyond the cavity. When intermediate mold section 35 and lower mold section 34 are closed, on the other hand, elastic member 58 starts to contract substantially simultaneously with downward movement of holding member 56 and mounting bars 57, and elastic member 58 most contracts when mold assembly 5 shown in Fig. 4 is closed.

Cavity member 52 is fitted around film adsorbing/fixing portion 53 of film fixing mechanism 51, as shown in Fig. 2. Cavity member 52 has an L-shaped section having a vertical portion and a horizontal portion.

The vertical portion of cavity member 52 includes the aforementioned cavity side surface 49, a substrate contact portion 59 coming into contact with substrate periphery 30 of substrate 14 while mold release film 36 is interposed and a chucking pawl storage portion 60 storing the forward ends of chucking pawls 42 not to damage substrate contact portion 59 when mold assembly 5 is closed.

A receiving member 61 receiving cavity member 52, a mounting member 62 for vertically moving cavity member 52 and receiving member 61 and a proper elastic member 63 such as a spring enclosing mounting member 62 are provided in the vicinity of the horizontal portion of the L-shaped section of cavity member 52. Elastic member 63 is in contact with the lower surface of receiving member 61 and the bottom surface of a hole of lower mold section 34.

When mold assembly 5 is opened as shown in Fig. 2, cavity side surface 49 of cavity member 52 stands by on a position upward beyond lower mold section cavity surface 48 and downward beyond the upper surface of holding member 56. At this time, elastic member 63 expands. When mold assembly 5 is closed as shown in Fig. 5, on the other hand, cavity member 52 comes into contact with the upper surface of lower mold section 34, and elastic member 63 most contracts.

When mold release film 36 covers lower mold section cavity surface 48, intermediate mold section 35 and lower mold section 34 are first closed from the state where mold assembly 5 is opened as shown in Fig. 2. Thus, mold release film 36 is held by intermediate mold section 35 and lower mold section 34 through the function of film holding/fixing portion 54, and forcibly sucked by film adsorbing/fixing portion 53 toward lower mold section cavity surface 48. Thus, mold release film 36 is fixed in a strained state along the shape of cavity 47 formed by lower mold section cavity surface 48 and cavity side surface 49, as shown in Fig. 3.

After mold assembly 5 shown in Fig. 5 is closed and a necessary time for curing molten resin in cavity 47 elapses, resin compact 19, i.e., cured resin 32 is formed. Consequently, substrate 14, i.e., molded substrate 20 is completed.

Further, upper sealing member 64 coming into contact with upper mold section side mold surface 43 of intermediate mold section 35 and a lower sealing member 65 coming into contact with lower mold section side mold surface 45 of intermediate mold section 35 are mounted on the mold surfaces of upper mold section 33 and lower mold section 34 respectively. Upper and lower sealing members 64 and 65 and evacuation mechanism unit 500 are so utilized as to execute evacuation of mold assembly 5 according to this embodiment.

While mold assembly 5 having upper sealing member 64 and lower sealing member 65 provided on upper mold section 33 and lower mold section 34 respectively is employed, a mold assembly having only upper sealing member 64 provided on upper mold section 33 may alternatively be employed.

Both of upper sealing member 64 and lower sealing member 65 are mounted on an upper seal fixing portion 66 and a lower seal fixing portion 67 in states protruding from the surfaces on outer sides of substrate fixing mechanism 38 and film fixing mechanism 51. Materials such as hollow seals or O-rings excellent in elasticity, heat resistance and durability can be employed as the materials of upper sealing member 64 and lower sealing member 65.

In evacuation of mold assembly 5, upper sealing member 64 first exhibits the function between upper mold section 33 and intermediate mold section 35. At this time, upper mold section side mold surface 43 of intermediate mold section 35 comes into contact with upper sealing member 64. Thus, upper sealing member 64 is crushed. Thus, the internal space of cavity 47 is cut off from the outside air. In other words, an internal air isolation space is formed. Substantially at the same time, air, moisture, gas etc. are forcibly discharged by evacuation mechanism unit 500 through a passage, a pipe and a valve communicating with the internal air isolation space.

Thus, evacuation molding is employed in the resin molding method according to this embodiment, whereby chips 15 mounted on substrate 14 can be sealed without forming voids etc. in resin material 18.

The resin sealing/molding method according to this embodiment is now described in detail stepwise.

First, upper mold section 33, lower mold section 34 and intermediate mold section 35 are opened, as shown in Fig. 2. In this state, mold release film 36 is inserted between the upper surface of holding member 56 of film holding/fixing portion 54 and lower mold section side mold surface 45 of intermediate mold section 35, i.e., between the upper surface of lower mold section cavity surface 48 and the lower surface of intermediate mold section 35 in a substantially horizontal and tensioned state. On the other hand, chucking pawls 42 of substrate holding/fixing portion 40 of upper mold section 33 stand by in the substantially horizontally extending state, i.e., a closed state.

Then, intermediate mold section 35 moves downward while mold release film 36 is in contact with lower mold section side mold surface 45 of intermediate mold section 35, whereby mold release film 36 is held by lower mold section side mold surface 45 and the upper surface of holding member 56. At this time, mounting bars 57 of film holding/fixing portion 54 move downward, and elastic member 58 contracts.

Then, intermediate mold section 35 and holding member 56 integrally move downward while mold release film 36 is held by intermediate mold section 35 and holding member 56 of lower mold section 34, whereby the lower surface of holding member 56 and the upper surface of the horizontal portion of cavity member 52 come into contact with each other. Substantially at the same time, mold release film 36 is forcibly sucked by film adsorbing/fixing portion 53 of film fixing mechanism 51 toward lower mold section cavity surface 48 on the region inside substrate contact portion 59.

At this time, substrate contact portion 59 is stored in the space in upper storage portion 44 and lower storage portion 46 of intermediate mold section 35. Inside substrate contact portion 59, mold release film 36 is held by intermediate mold section 35 and holding member 56. Further, mold release film 36 is in an expanding state due to heating of mold assembly 5 for melting resin material 18. Therefore, mold release film 36 reliably adheres to cavity 47 of lower mold section 34 inside substrate contact portion 59.

Then, in the state where intermediate mold section 35 and lower mold section 34 are closed as shown in Fig. 3, mold release film 36 is continuously forcibly sucked toward lower mold section cavity surface 48 inside substrate contact portion 59, whereby mold release film 36 adheres in the tensioned state along the shape of the overall surface of cavity 47 including cavity surface 50 formed by lower mold section cavity surface 48 and cavity side surface 49, as shown in Fig. 3. Thus, a molding space corresponding to resin compact 19 (package) is formed on substrate 14, as shown in Fig. 3.

Then, preparation for supplying resin material 18 into cavity 47 is executed in this state. On the other hand, chucking pawls 42 stand by in the open state, not to collide with substrate 14 (pre-molding substrate 17) when pre-molding substrate 17 is supplied to/set on upper mold section 33.

Then, resin material 18 is supplied into the molding space of cavity 47 as shown in Fig. 4, in the state where the aforementioned molding space of cavity 47 is formed. Fig. 4 shows cavity 47 as viewed obliquely from above without upper mold section 33 and intermediate mold section 35, for easy understanding of lower mold section 34.

Then, intermediate mold section 35 and lower mold section 34 integrally move toward upper mold section 33. At this time, substrate periphery 30 of pre-molding substrate 17 is fixed by chucking pawls 42 while unmounted surface 31 of pre-molding substrate 17 is adsorbed to substrate mounting surface 37 of upper mold section 33. Thus, pre-molding substrate 17 is reliably fixed to upper mold section 33 by substrate fixing mechanism 38. Resin material 18 supplied into the molding space of cavity 47 is heated to a prescribed temperature necessary for melting the same by heating overall mold assembly 5. Thus, resin material 18 is converted to the molten resin. Further, mold release film 36 covers cavity 47 in the tensioned state, and is reliably covered with the molten resin along the shape of the overall surface of cavity 47 with no film wrinkles. Mold release film 36 on lower mold section cavity surface 48 is adsorbed due to the function of film adsorbing/fixing portion 53 of film fixing mechanism 51.

As shown in Figs. 2 to 4, mounting of pre-molding substrate 17 on upper mold section 33, formation of the molding space of cavity 47, preheating of overall mold assembly 5 and supply of resin material 18 into the molding space of cavity 47 may be executed along any sequence, so far as these steps are completed before an evacuation step described later.

Then, intermediate mold section 35 and lower mold section 34 integrally move toward upper mold section 33 while the molten resin is supplied into the molding space in cavity 47 through mold release film 36. Thus, upper mold section side mold surface 43 of intermediate mold section 35 comes into contact with upper sealing member 64 mounted on upper mold section 33, and upper sealing member 64 is crushed. At this time, the molding space in cavity 47 is cut off from the outside air. Substantially at the same time, the evacuation mechanism forcibly discharges the air from the molding space through the passage communicating with the molding space.

Resin material 18 in the molding space of cavity 47 may not be molten in the aforementioned state where mold assembly 5 is closed, but may be in the state of the molten resin before evacuation is stopped.

The evacuation step for mold assembly 5, executed before mold assembly 5 is completely closed according to this embodiment, may be intermittently executed by alternately changing mold assembly 5 between the completely closed state and a slightly opened state, or may be continuously executed without stopping mold assembly 5 in a state where the traveling speed of lower mold section 34 and intermediate mold section 35 is reduced during transition from the state immediately before mold assembly 5 is completely closed to the state where mold assembly 5 is completely closed.

Then, intermediate mold section 35 and lower mold section 34 integrally move upward. Thus, upper mold section side mold surface 43 of intermediate mold section 35 comes into contact with the mold surface of upper mold section 33. Substantially at the same time, substrate contact portion 59 comes into contact with substrate periphery 30 of pre-molding substrate 17 with the interposition of mold release film 36.

At this time, chips 15 serving as electronic components are dipped in the molten resin in cavity 47. Chuck pawls 42 are stored in upper storage portion 44 of intermediate mold section 35 and chucking pawl storage portion 60 of cavity member 52 in the state stopping substrate periphery 30 of pre-molding substrate 17.

Thus, substrate contact portion 59 is reliably pressed against the perimeter of substrate periphery 30 of substrate 14 in the state protruding in cavity 47. Even if the molten resin is pressed against chips 15 in the state where mold assembly 5 is closed as shown in Fig. 4, therefore, the molten resin is prevented from leaking onto substrate 14 outside substrate periphery 30.

While such mold assembly 5 that upper mold section side mold surface 43 of intermediate mold section 35 comes into contact with the mold surface of upper mold section 33 when mold assembly 5 is closed is employed, the mold surface of upper mold section 33 and upper mold section side mold surface 43 may separate from each other so far as upper sealing member 64 is completely crushed and the internal space of mold assembly 5 is cut off from the outside air.

The evacuation step may be terminated at any timing between the state immediately before mold assembly 5 is completely closed and the state where mold assembly 5 is completely closed (see Fig. 4). However, evacuation is preferably continued until resin sealing is completed, and preferably terminated after the resin sealing is completed.

Then, only lower mold section 34 moves upward from the state where substrate contact portion 59 is in contact with pre-molding substrate 17 as shown in Fig. 5, whereby chips 15 are sealed by compression molding of resin material 18. In this state where holding member 56 and cavity member 52 are in contact with each other as shown in Fig. 5, the lower surface of cavity member 52 moves downward to come into contact with the upper surface of lower mold section 34. At this time, the respective ones of elastic members 58 and 63 provided on lower mold section 34 most contract. Thus, mold assembly 5 is completely closed.

The position of lower mold section cavity surface 48 forming the bottom surface of the molding space of cavity 47 can be changed in the vertical direction of the figure, for example, so that the volume of the resin in the molding space of cavity 47 can be properly adjusted in the state where mold assembly 5 according to this embodiment is closed.

A measuring apparatus (not shown) such as a pressure sensor capable of monitoring the clamp pressure at the time when mold assembly 5 is closed may be stored in film adsorbing/fixing portion 53 of lower mold section 34.

Then, the time necessary for curing the molten resin covering chips 15 elapses while mold assembly 5 is completely closed as shown in Fig. 5. Thus, resin compact 19, i.e., cured resin 32 covering chips 15 is molded. Consequently, molded substrate 20, i.e., the product is completed. While substrate fixing mechanism 38 and film fixing mechanism 51 continuously exhibit the sucking functions at this time, the function of either or both of these may alternatively be stopped.

Then, molded substrate 20 is separated from mold assembly 5 and mold release film 36. Therefore, only intermediate mold section 35 and lower mold section 34 move downward from the state where mold assembly 5 is completely closed as shown in Fig. 5. Thus, a clearance is formed between molded substrate 20 provided with resin compact 19, i.e., cured resin 32 and mold release film 36 and lower mold section cavity surface 48. Substantially at the same time, air is sprayed from lower mold section cavity surface 48 to molded substrate 20 through a pressure mechanism provided on film adsorbing/fixing portion 53 of film fixing mechanism 51. Thus, molded substrate 20 is completely separated from lower mold section cavity surface 48 along with mold release film 36.

Then, intermediate mold section 35 and lower mold section 34 further move downward, whereby upper mold section 33, intermediate mold section 35 and lower mold section 34 are completely opened. At this time, molded substrate 20 is mounted on substrate mounting surface 37 of upper mold section 33.

Then, chucking pawls 42 rotate with respect to substrate mounting surface 37 of upper mold section 33 and open substantially similarly to the state of mold assembly 5 shown in Fig. 3, and molded substrate 20 is dismounted from substrate mounting surface 37 of the mold surface of upper mold section 33.

While the case where apparatus 1 seals/molds semiconductor chips 15 with resin has been described in this embodiment, the resin sealing/molding apparatus according to the present invention may be any one so far as plurality of mold assemblies 5 for compression molding each resin-sealing one pre-molding substrate 17 through execution of the aforementioned series of resin sealing steps are linked with each other and a control unit continuously or intermittently controls the series of resin sealing steps.

Although the present invention has been described and illustrated in detail, it is clearly understood that the same is by way of illustration and example only and is not to be taken by way of limitation, the scope of the present invention being interpreted by the terms of the appended claims.

## Claims

1. A resin sealing/molding apparatus comprising:
an in unit (4) having a substrate mechanism (2) transferring a pre-molding substrate (17) mounted with a plurality of semiconductor chips (15) and a resin material mechanism (3) transferring a resin material (18);
a plurality of press units (7) each including a press mechanism (6) loaded with a mold assembly (5) having an upper mold section (33), a lower mold section (34) and an intermediate mold section (35) provided between said upper mold section (33) and said lower mold section (34);
an out unit (9) having a substrate mechanism (8) transferring a molded substrate (20) resin-sealed in said mold assembly (5);
a carrier rail (10) so provided as to cross said in unit (4), said press units (7) and said out unit (9);
a supply mechanism (11) traveling along said carrier rail (10) for supplying said pre-molding substrate (20) into said mold assembly (5);
a demounting mechanism (12) traveling along said carrier rail (10) for demounting said molded substrate (20) from said mold assembly (5); and
a control mechanism (100) controlling said in unit (4), said press units (7) and said out unit (9), wherein
said plurality of press units (7) are disposed between said in unit (4) and said out unit (9) in a state linked with each other.

2. The resin sealing/molding apparatus according to claim 1, wherein
each of said plurality of mold assemblies (5) includes:
a film supply mechanism unit (13) supplying a tensioned mold release film (36) between said intermediate mold section (35) and said lower mold section (34), and
an evacuation mechanism unit (500) executing evacuation of said mold assembly (5) while the internal space of said mold assembly (5) is cut off from the outside air.

## Amended claims

### Amended claims under Art. 19.1 PCT

**1.** (Amended) A resin sealing/molding apparatus comprising:
an in unit (4) having a substrate mechanism (2) transferring a pre-molding substrate (17) mounted with a plurality of semiconductor chips (15) and a resin material mechanism (3) transferring a resin material (18);
one or at least two press units (7) each including a press mechanism (6) loaded with a mold assembly (5) for compression molding having an upper mold section (33), a lower mold section (34) and an intermediate mold section (35) provided between said upper mold section (33) and said lower mold section (34) and resin-sealing one pre-molding substrate (17);
an out unit (9) having a substrate mechanism (8) transferring a molded substrate (20) resin-sealed in said mold assembly (5);
a carrier rail (10) so provided as to cross said in unit (4), said one or at least two press units (7) and said out unit (9);
a supply mechanism (11) traveling along said carrier rail (10) for supplying said pre-molding substrate (20) into said mold assembly (5);
a demounting mechanism (12) traveling along said carrier rail (10) for demounting said molded substrate (20) from said mold assembly (5); and
a control mechanism (100) controlling said in unit (4), said one or at least two press units (7) and said out unit (9), wherein
said one press unit is disposed between said in unit (4) and said out unit (9) in a mountable and dismountable state, or said at least two press units (7) are disposed between said in unit (4) and said out unit (9) in a state mountable and dismountable and linked with each other.

**2.** (Amended) The resin sealing/molding apparatus according to claim 1, wherein
each of said one or at least two mold assemblies (5) includes:
a film supply mechanism unit (13) supplying a tensioned mold release film (36) between said intermediate mold section (35) and said lower mold section (34) in said mold assembly (5), and
an evacuation mechanism unit (500) executing evacuation of said mold assembly (5) while the internal space of said mold assembly (5) is cut off from the outside air.
